# EUROPEAN PATENT APPLICATION

(11) **EP 1 528 122 A1**
(43) Date of publication of application: **04.05.2005**
(21) Application number: 04024771.0
(22) Date of filing: 18.10.2004
(51) Int. Cl.: C23C 16/455, C23C 16/458, C30B 25/14

(54) **Chemical vapor deposition unit**

(30) Priority: 31.10.2003 KR 2003076799
(71) Applicant: Sysnex Co., Ltd., Daejeon 305-313 (KR)
(72) Inventor: Lee, Kyeong, Ha, Seongnam-si Gyeonggi-do 463-060 (KR); Kim, Sang, Chul, Daedeok-gu Daejeon 306-040 (KR); Jung, Do, II, Daejeon 301-142 (KR); Park, Hyun, Soo, Dong-gu Daejeon 300-130 (KR)
(74) Representative: Wagner, Bernhard Peter

(57) **Abstract**

A chemical vapor deposition unit for vapor-depositing uniform thin film over the entire area of a substrate 200. The chemical vapor deposition unit includes a reaction chamber 100 isolated from the outside and kept under vacuum, a susceptor 200, on which at least one substrate P is placed, rotatably installed in the reaction chamber 100, and an injector 300, including independently formed first and second gas passages 340 and 350, and first and second gas injecting pipes 370 and 380, communicating with the respective gas passages 340 and 350 at respective inlets, for injecting respective first and second gases G1 and G2 onto the susceptor 200, the injector 300 injecting the different gases independently. The injector 300 further includes a gas injecting part 331 communicating with the second gas passage 350 so that a carrier gas, only the second gas G2, which is a non-reactive carrier gas, among the first and second gases G1 and G2, is injected to a central region 210 of the susceptor 200.

## Description

### BACKGROUND OF THE INVENTION

### Field of the Invention

The present invention relates to a chemical vapor deposition unit, and more particularly to a chemical vapor deposition unit for a forming uniform thin film over the whole area of a substrate by making flow of different kinds of gases smooth to vaporize a thin film on a substrate.

### Description of the Related Art

Generally, semiconductors are manufactured by the process of constructing electric circuits, repeatedly performing a diffusion process, photographing process, etching process, and thin film process, on a substrate, as a raw material.

The thin film process, among the manufacturing processes for the semiconductor, is a process of vapor-depositing a thin film on a substrate to a desired thickness. Among the vapor deposition methods, there are chemical vapor deposition, ion injection, metal vapor deposition, and the like.

Metal organic chemical vapor deposition, one of the chemical vapor deposition methods, is a method of forming a thin film on a heated substrate by using pyrolysis and re-reaction. In metal organic chemical vapor deposition, a group III element gas and ammonia gas are injected into a reactor and undergo pyrolysis and chemical reactions, so that a nitride thin film is grown on the substrate. Metal organic chemical vapor deposition is widely used because of its ability to easily create the grown layer and low maintenance, low price, and specific and precise controllability.

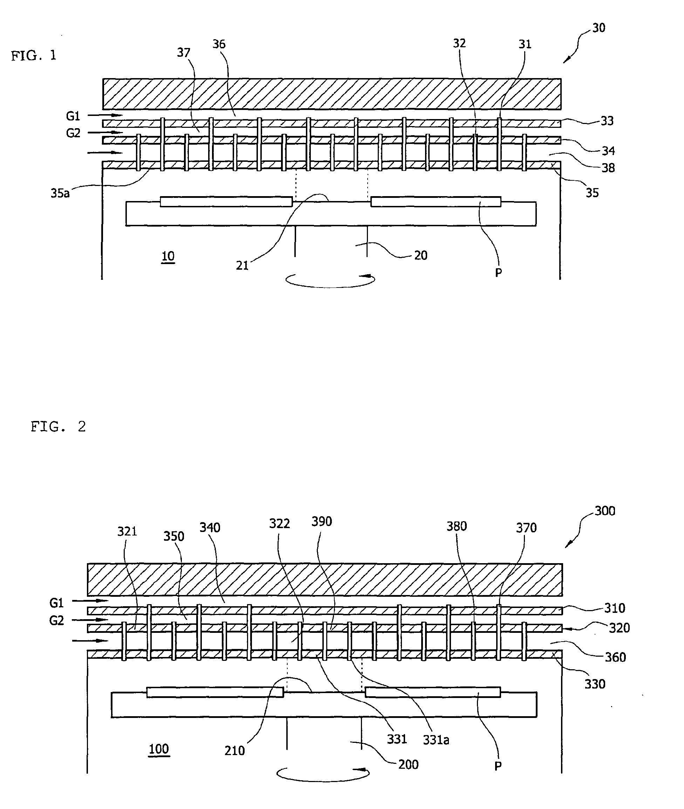

As shown in Fig. 1, a conventional chemical vapor deposition unit includes an isolated reaction chamber 10, kept under vacuum, a susceptor 20 installed in the reaction chamber 10, in which a substrate P is placed, and a gas injector 30 for injecting different gases to form a thin film on the substrate P placed on the susceptor 20.

The gas injector 30, for example, includes a first gas injecting pipe 31 for injecting a first gas G1, a second gas injecting pipe 32 for injecting a second gas G2, and passages which form respective, independent passages, such as a first gas passage 36, a second gas passage 37, and a coolant passage 38, by horizontal partitions 33, 34, and 35 from the upper side as seen in the drawing.

In order to inject the first and second gases G1 and G2 along the respective passages 36 and 37, the tube-type first and second gas injecting pipes 31 and 32 differ in length. The partition 33 is installed between entrances of the first and second gas injecting pipes 31 and 32 so as to divide the passage into the first gas passage 36 at the upper side and the second gas passage 37 at the lower side.

An injecting surface 35a and the surface of the susceptor 20, as injecting sides of the first and second gas injecting pipes 31 and 32, are flat and they are positioned so as to have a uniform gap therebetween.

The coolant passage 38 is disposed at the lower side of the second gas passage 37, and respective gas injecting pipes 31 and 32 penetrate the coolant passage 38.

According to the conventional chemical vapor deposition unit, the first and second gases G1 and G2 flow through the respective gas passages 36 and 37, partitioned by the first partition 33, and are injected onto the substrate P being rotated by the susceptor 20 through the first and second gas injecting pipes 31 and 32. Simultaneously, the substrate P is heated, and the first and second gases G1 and G2 undergo pyrolysis and are re-reacted, so that the thin film is formed on the substrate P. On the other hand, the coolant flowing through the coolant passage 380 regulates temperature of the injector 30.

As described above, since chemical vapor deposition grows the thin film on the substrate P in the manner that the first and second gases G1 and G2 undergo pyrolysis over the heated susceptor 20 and are re-reacted with each other on the substrate P, the flow rate, density, and temperature of the gas are closely related.

Moreover, in the growth of the thin film, the gas exhibits a laminar flow, the growth rate of the thin film increases as the flow rate of the reactive gas increases and the density (mixture rate) of the reactive gases are greater.

Since the above-mentioned factors must be controlled, the conventional chemical vapor deposition unit has disadvantage as follows.

Since the gap between the gas injecting surface 35a and the surface of the susceptor 20, and since a predetermined amount, of gases G1 and G2, per unit area, is injected at the gas injecting surface 35a, in the reaction of the first and second gases G1 and G2 at the central region, the density of the first gas G1 over the substrate P near to the central region 21 of the susceptor 20 is increased so that the thickness of the substrate P corresponding to the central region 21 is also increase, and thus the thickness of the thin film is not uniform.

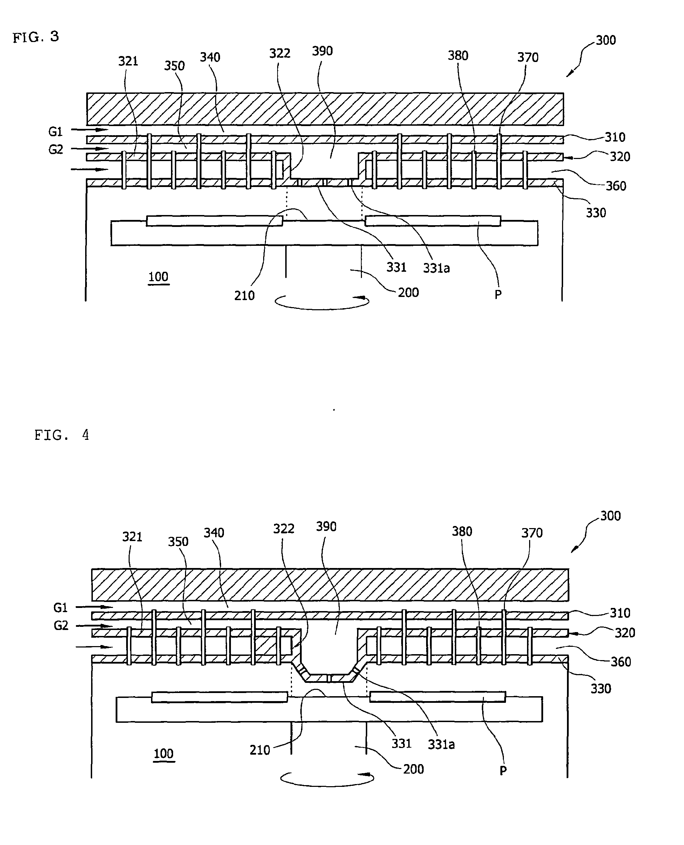

If the susceptor 20 is rotated in an attempt to provide a uniform thickness, the relative velocity at the central region of the susceptor 20 is slower than the relative velocity at the outer region of the susceptor 20. The difference between the relative velocities is adjusted by the revolutions per minute of the susceptor 20. The growth rate of the thin film on the substrate P, near the central region 21, is adjusted to be similar to the growth rate on the substrate P facing the outer region of the susceptor 20, so that uniform thickness can be obtained. However, the first and second gases G1 and G2, injected from the central region of the gas injecting surface 35a, react at the central region 21 where there is no substrate P, so that by-products are generated. The by-products pass over the substrate P placed on the susceptor 20, together with the gas flow. The by-products interfere with the deposition on the substrate P, and as a result, the uniform thickness and quality of the thin film are deteriorated so that a semiconductor device of poor quality may be produced. In contrast, the present invention can eliminate the by-products at the central region 21 of the susceptor 20 by using a showerhead (See Figs. 2 and 3) for injecting only the second gas at the central region 21.

Moreover, since the susceptor 20 must be rotated during heating thereof, it is difficult to directly heat the central region 21 of the susceptor 20. Although heating the susceptor 20 by using the heat conductivity of the susceptor materials, the temperature of the central region 21 is lower than that of the outer region thereof. In other words, it is difficult to perform the thin film vapor deposition on the substrate P over the central region 21 of the susceptor 20. As s result, the reactive gas is wasted.

Therefore, the conditions under which the conventional gas injector for chemical vapor deposition can obtain a uniform thin film can be optimized by adjusting the density of the injected gas and the revolutions per minute of the susceptor 20. However, there is a limit to which the uniformity of the thickness and quality of the thin film can be optimized, due to the by-products at the central region. Further, when, for the purpose of enhancing productivity of the high quality thin film, the thin film is grown on tens of substrates P in a single process, uniform thin film may be obtained. However, since the by-products are increased as the amount of gas is increased, it is almost impossible to achieve high productivity and high quality of the semiconductor.

In contrast, a gas injector according to the present invention injects one gas from a central portion thereof so as to remove the by-products generated at the central region of the susceptor 20. Thus, a high quality thin film can be obtained.

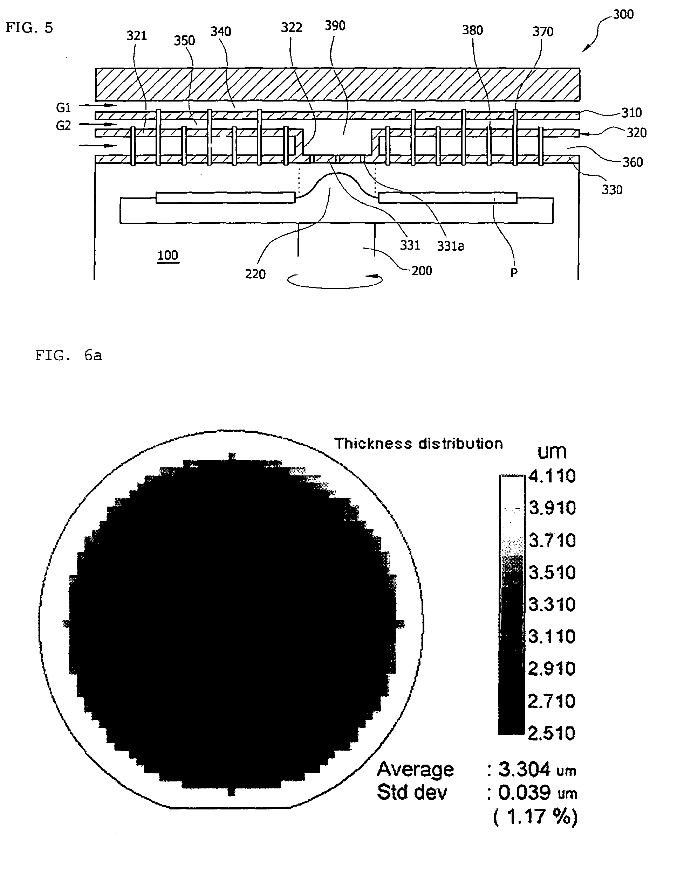

Moreover, since the gas injecting surface 34 and the opposite surface of the susceptor 20 are flat, the gas injected toward the right central region of the susceptor 20 exhibits a stagnant flow. For this reason, the reactive gases on the substrate is interfered and does not exhibit a laminar flow, so that the reacted gases are not deposited on the substrate P. In contrast, a gas injector (See Fig. 4) and a susceptor (See Fig. 5) of the present invention minimize the stagnant flow at the central region of the susceptor, so that the gas flow can be enhanced over the entire region of the susceptor 20.

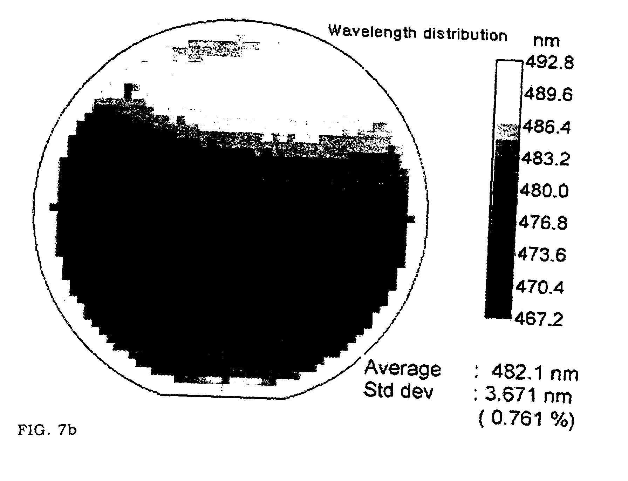

Figs. 7a and 7b illustrate the thickness and wavelength PL data of the thin film vapor-deposited by the conventional chemical vapor deposition unit. In the drawings, the average thickness of the thin film is 3.057µm, the minimum thickness is 2.991µm, and the maximum thickness is 3.302µm, thus there is a great difference therebetween. Meanwhile, the standard deviation of the thickness is 2.11%, this is too bad for the production of commercial thin films. When seeing the wavelength data, the minimum wavelength is 477.7nm, the maximum wavelength is 492.0nm, and the standard deviation of the wavelength is 3.671nm. Since the thickness is not uniform over whole substrate, the wavelength is also not uniform and the thickness of the thin film does not satisfy the condition of the commercial thin films.

### SUMMARY OF THE INVENTION

Therefore, the present invention has been made in view of the above problems, and it is an object of the present invention to provide a chemical vapor deposition unit having a gas injector for injecting a single gas from a central portion thereof so as to remove by-products generated at the central region of a susceptor and to enhance the uniformity of thickness and quality of the thin film.

It is another object of the present invention to provide a chemical vapor deposition unit capable of enhancing the uniformity of thickness of the thin film by reducing the difference between densities of gases (ratio of the mixture) over the entire region of a substrate by injecting reactive gases only on the substrate.

It is yet another object of the present invention to provide a chemical vapor deposition unit capable of obtaining laminar flow of gas over the entire region of a susceptor by removing the stagnant flow generated at regions where reaction is unnecessary, that is, a region from the central region of a gas injector of the chemical vapor deposition unit to the central region of the susceptor.

In accordance with an object of the present invention, the above and other objects can be accomplished by the provision of a chemical vapor deposition unit including a reaction chamber isolated from the outside and kept under vacuum, a susceptor rotatably installed in the reacting chamber and on which at least one substrate is placed, and an injector, including independently formed first and second gas passages, and first and second gas injecting pipes, communicating with the respective gas passages at respective inlets, for injecting respective first and second gases onto the susceptor, the injector injecting the different gases independently, wherein a portion, corresponding to a central region of the susceptor, is installed with only the second gas injecting pipe so that only the second gas, which is a non-reactive carrier gas, among the first and second gases, is injected at the central region of the susceptor.

In accordance with another object of the present invention, there is provided a chemical vapor deposition unit including a reaction chamber isolated from the outside and kept under vacuum, a susceptor, on which at least one substrate is placed, rotatably installed in the reaction chamber, and an injector, including independently formed first and second gas passages, and first and second gas injecting pipes, communicating with the respective gas passages at respective inlets, for injecting respective first and second gases onto the susceptor, the injector injecting the different gases independently, wherein the injector further includes a gas injecting part communicating with the second gas passage so that a carrier gas, only the second gas, which is a non-reactive carrier gas, among the first and second gases, is injected to a central region of the susceptor.
chemical vapor deposition unit including a reaction chamber isolated from the outside and kept under vacuum, a susceptor, on which at least one substrate is placed, rotatably installed in the reaction chamber, and an injector, including independently formed first and second gas passages, and first and second gas injecting pipes, communicating with the respective gas passages at respective inlets, for injecting respective first and second gases onto the susceptor, the injector injecting the different gases independently, wherein the injector further includes a gas injecting part communicating with the second gas passage so that only the second gas, which is non-reactive carrier gas, among the first and second gases, is injected to a central region of the susceptor.

Preferably, a second gas region having a cross-sectional area greater than that of other region may be further formed between the second gas passage and the gas injecting part.

### BRIEF DESCRIPTION OF THE DRAWINGS

These and/or other objects and advantages of the present invention will become apparent and more readily appreciated from the following description of the embodiments, taken in conjunction with the accompanying drawings, in which:
Fig. 1 is a schematic view illustrating a convention chemical vapor deposition unit;
Fig. 2 is a schematic structural view illustrating a chemical vapor deposition unit according to a first embodiment of the present invention;
Fig. 3 is a schematic structural view illustrating a chemical vapor deposition unit according to a second embodiment of the present invention;
Fig. 4 is a schematic structural view illustrating a chemical vapor deposition unit according to a third embodiment of the present invention;
Fig. 5 is a schematic structural view illustrating a chemical vapor deposition unit according to a fourth embodiment of the present invention;
Figs. 6a and 6b are diagrams illustrating the thickness and wavelength PL data of a thin film grown on the substrate by the chemical vapor deposition unit according to the respective embodiments of the present invention; and
Figs. 7a and 7b are diagrams illustrating the thickness and wavelength PL data of a thin film grown on the substrate by the conventional chemical vapor deposition unit.

### DESCRIPTION OF THE PREFERRED EMBODIMENTS

The present invention is characterized in that different gases for forming a thin film on a substrate can form a uniform thin film regardless of where the substrate is placed on the susceptor, and quality of products can be enhanced. The conditions which must be satisfied in order to achieve the present invention are as follows.

(1) There must be no by-products, which are generated by the reaction between a first gas and a second gas at the central region of the susceptor and interfere with the vapor deposition on the substrate.

As the capacity and/or volume of the equipment is increased, the diameter of the susceptor and the number of the substrates used at once are increased. The uniformity of the thin films grown on the plural substrates must be enhanced. Further, the quality of a substrate place on the central region of the susceptor must not be different from the quality of a substrate placed on the outer region of the susceptor. This means that to remove the by-products from the central region of the susceptor, where the thin film cannot grow at low temperatures caused by structural problems of the susceptor, t is necessary to inject the reactive gases from a region other than the central region of the gas injector. However, if no gas flows through the central region of the susceptor, there is generated so called "dead volume" where the gas remains. If the gases injected in the previous process are diffused, for even a few seconds, in a process in which various reactive gases, for example, a dopant gas, must be used, the diffusion affects the subsequent process. If the same reactive gases as the gases injected on the substrate placed on the outer region of the susceptor are injected on the substrate placed on the central region of the susceptor in the conventional manner, productivity and quality of the thin film grown on the central substrate are deteriorated due to the variation of the thickness and formation of by-products.

This problem can be solved by removing the dead volume where the gas remains. In other words, only carrier gas, which does not directly react on the substrate, is allowed to flow over the substrate placed on the central region of the susceptor.

(2) The stagnant flow due to the rotation of the susceptor is reduced so that gas flow is rapid and laminar flow is smooth.

If different gases are simultaneously injected from the central region of the susceptor and flow out of the susceptor, the different gases collide with the by-products generated by the reaction of the different gases in the stagnant area. Thus, smooth laminar flow of the gases may result so that a great difference between the thickness of the thin film at the inner region of the substrate and the thickness of the thin film at the outer region of the substrate. This is an important factor because uniformity of thin film thickness determines the quality and productivity of the semiconductor device.

The chemical vapor deposition units, according to the embodiments of the present invention, satisfying the above-described conditions, capable of forming the thin film uniformly on substrates placed on the entire region of the susceptor wherever the substrate is placed on the central region or the circumferential region of the susceptor, will be described in great detail.

### Embodiment 1

As shown in Fig. 2, a chemical vapor deposition unit, according to a first embodiment of the present invention, includes a reaction chamber 100, isolated from the outside, kept under vacuum, a susceptor 200, installed in the reaction chamber 100, where at least one substrate P is placed, and a gas injector 300 for injecting different gases to form a thin film on the substrate P placed on the susceptor 200.

The gas injector 300 includes a first gas passage 340, a second gas passage 350, and a coolant passage 360 independently formed by partitions 310, 320, and 330, disposed in turn from an upper side to a lower side as seen in the drawing, a first gas injecting pipe 370 for injecting a first gas G1, and a second gas injecting pipe 380 for injecting a second gas G2.

In order that the first and second gases G1 and G2 can be injected along the respective passages 340 and 350, the tube type first and second gas injecting pipe 370 and 380 have different respective lengths, and their upper inlets correspond to the first and second gas passages 340 and 350.

In this embodiment, in order to inject only the second gas G2 to a central region 210 of the susceptor 200, a region corresponding to the central region 210 is installed with only the second gas injecting pipe 380. In other words, the first gas injecting pipe 370 is installed at any region except the central region 210 of the susceptor 200.

The operation of the chemical vapor deposition unit according to this embodiment of the present invention is described as follows.

The first gas G1 supplied into the first gas passage 340 is injected onto the susceptor 200 through the first gas injecting pipe 370, and the second gas G2 supplied into the second gas passage 350 is injected onto the susceptor 200 through the second gas injecting pipe 380. At this time, since the two gases G1 and G2 are separated from each other until passing through the respective gas injecting pipes 370 and 380, there is a low possibility that the different gases G1 and G2 may react with each other. The first gas G1 and the second gas G2 passed through the respective gas injecting pipes 370 and 380, are respectively pyrolysed while passing over the rotating susceptor 200, and are recombined with the pyrolysed atoms, so that the gases G1 and G2 are vapor-deposited on the substrate P. Meanwhile, the injected gases G1 and G2 pass through the substrate P on the rotating susceptor 200. At this time, the first gas G1 and the second gas G2 have uniform density (ratio of mixture) over the entire area of the substrate P and react with each other, and then exit out the susceptor 200. As a result, a uniform thin film is generated on the substrate P.

During the process of thin film vapor deposition by the different kinds of gases G1 and G2, since the region corresponding to the central region 210 of the susceptor 200 is installed with only the second gas injecting pipe 380, only the second gas G2 is present in the central region 210. Therefore, in the central region 210 of the susceptor 200, there is no reaction between the gases G1 and G2 takes place. The second gas G2 occupies a space, where there is a shortage of the second gas G2, and meets the first gas G1 at the outer region of the susceptor 200, while exiting out the susceptor 200. At this time, the second gas G2 reacts with the first gas G1 and is deposited on the substrate P. Thus, the gases (having density: mixture ratio of the first and second gases G1 and G2) over the plural substrates P placed on the susceptor 200 are not concentrated at one side, but rather are uniformly distributed over the entire area, and there is no reaction at the central region 210 of the susceptor 200.

### Embodiment 2

A chemical vapor deposition unit according to this embodiment of the present invention has substantially the same structure as that of the first embodiment. However, the manufacturing process in this embodiment is simpler than that of the first embodiment, and the jointing spots of the gas injecting pipes with the partitions are also reduced by reducing the number of the gas injecting pipes, at the central region, for manufacturing the gas injector shown in Fig. 2. This reduces the number of inferior goods injectors which are produced.

As shown in Fig. 3, in this embodiment, only the second gas G2 is injected at the central region 210 of the susceptor 200 so that there is no reaction at the central region 210. By doing so, the second partition 320 for dividing the second gas passage 350 and the coolant passage 360, in order to uniformly deposit the thin film on the substrate P disposed over the entirely of the susceptor 200, has a ring-shaped central portion corresponding to the central region of the susceptor 200 as seen from above. In other words, the second partition 320 includes a horizontal part 321 and a vertical part 322, while the vertical part 322 is formed at the central portion corresponding to the central region 210 of the susceptor 200. The second partition 320 may be an integral structure in which the lower end of the vertical part 322 is integrally connected to the third partition 330.

Thus, at the central portion of the third partition 330 (a portion corresponding to the central portion of the second partition 320 and the central region 210 of the susceptor 200), the second gas injecting part 331 having an injecting hoe 331a is installed so as to inject only the second gas G2. The inside of the second partition 320 communicates with the second gas passage 350 and is defined with a second gas region 390.

During the thin film vapor deposition process using the different gases G1 and G2, part of the carrier gas, i.e., the second gas G2, flows toward the injecting hole 331a of the second gas injecting part 331 via the second gas region 390. At this time, since the only gas injected from the center of the gas injector is the second gas, at the central region 210 of the susceptor 200, there is no reaction between the gases G1 and G2. The second gas G2 occupies a space, where there is a shortage of the second gas G2, and meets the first gas G1 while exiting out the susceptor 200. At this time, the second gas G2 reacts with the first gas G1 and is deposited on the substrate P. Thus, the gases (having density: mixture ratio of the first and second gases G1 and G2), over the plural substrates P placed on the susceptor 200 are not concentrated at one side, but rather are uniformly distributed over the entire area, and there is no reaction at the central region 210 of the susceptor 200.

### Embodiment 3

As shown in Fig. 4, a chemical vapor deposition unit according to this embodiment of the present invention is substantially the same as that of the chemical vapor deposition unit according to the first embodiment. However, the second gas injecting part 331 has an arc-shape, protruded toward the susceptor 200, so that the second gas G2, injected through the injecting hole 331a of the second injecting part 331, can be smoothly injected.

According to this embodiment, the second gas G2, passed through the second gas region 390, is guided to flow toward the circumferential side of the susceptor 200 via the injecting hole 331, formed toward the circumferential side of the susceptor 200. Thus, the unused reaction space of the susceptor 200 and the stagnant flow are minimized, so that the gas flow can be improved.

### Embodiment 4

As shown in Fig 5, a chemical vapor deposition unit according to this embodiment of the present invention is substantially the same as that of the chemical vapor deposition unit according to the second embodiment, and further includes a guide part 220. The guide part 220 is formed at the central region of the susceptor 200 corresponding to the second gas injecting part 331, and guides the flow of the second gas G2 injected through the second gas injecting part 331.

The guide part 220 serves to remove the stagnant flow of the second gas G2 injected through the second gas injecting part 331, so that the first and second gases G1 and G2 injected onto the susceptor 200 exhibits laminar flow over the entire area. Although Fig. 5 shows a convex type guide part 220, the shape of the guide part 220 is not limited to the convex style and any shape which helps the flow of the second gas G2 are possible.

In addition, although the guide part 220 of this embodiment has been described only as being applied to the second embodiment, the guide part 220 may be applied to the first and third embodiments by modifying its structure and/or shape.

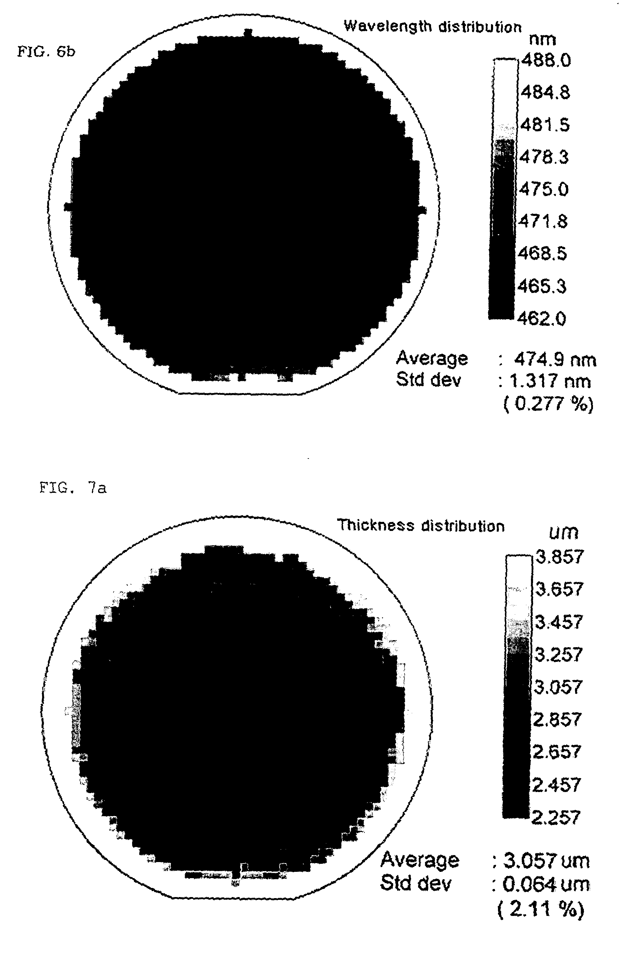

Figs. 6a and 6b show the thickness and wavelength PL data of the thin film grown on the substrate by the chemical vapor deposition unit according to the respective embodiments of the present invention. In comparison with the thickness of the thin film grown by the conventional chemical vapor deposition unit shown in Fig. 7a, the average thickness of the thin film grown by the chemical vapor deposition unit, according to the respective embodiments of the present invention, is 3.304µm, an increase of 8.08%. In comparison with the thickness of the thin film grown by the conventional chemical vapor deposition unit shown in Fig. 7a, the standard deviation of the thickness of the thin film grown by the chemical vapor deposition unit, according to the respective embodiments of the present invention, is 0.039µm, an enhancement of 44.5%. The increased thickness growth rate decreases gas consumption for thin films of equal thicknesses. As seen in the wavelength PL data, the standard deviation of the wavelength in the present invention is 1.317nm, an enhancement of 64.1%, in comparison with the standard deviation of the wavelength of the thin film grown by the conventional chemical vapor deposition unit shown in Fig. 7b. This shows that wavelength is uniform when the thin film is grown uniformly over the entire area of the substrate. In other words, it demonstrates that productivity of the substrate can be enhanced.

As described above, according to the chemical vapor deposition unit of the present invention, the reaction in the central region of the rotating susceptor is restrained, so that the thin film can be uniformly vapor-deposited on substrates disposed over the entire region of the susceptor. Tables 1 and 2 show the wavelength PL data and the thickness of the thin film grown by the chemical vapor deposition units according to the embodiments of the present invention. In Table 1, the thickness in the present invention is increased by 8.08%, and the standard deviation of the thickness is increased by 44.5% in comparison with the thickness and the standard deviation of the thickness in the conventional chemical vapor deposition unit. This means that the increase of the thickness growth rate of the thin film can reduce the amount of injected source materials by about 8%.

**Table 1**

| | Conventional unit | Present invention | Enhancement (%) |
|---|---|---|---|
| Average thickness (µm) | 3.057 | 3.304 | 8.08% |
| Standard deviation(%) | 2.11 | 1.17 | 44.5% |

In Table 2, in comparison with the standard deviation of wavelength in the convention chemical vapor deposition unit, the standard deviation of wavelength in the chemical vapor deposition unit according to the present invention is enhanced by 64.1%. This means that productivity of the substrate can be enhanced, so that a high quality thin film can be grown. Moreover, since only a small amount of by-products is generated, the time necessary to remove the by-products in order to perform the next process can be reduced so that productivity is enhanced.

**Table 2.**

| | Conventional unit | Present invention | Enhancement (%) |
|---|---|---|---|
| Standard deviation (nm) | 3.671 | 1.317 | 64.1% |

Table 2 shows that the thin film can be grown on tens of substrates at once, and the thickness uniformity of the thin film over all substrates enables mass-production of high quality thin films.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A chemical vapor deposition unit comprising:
a reaction chamber 100 isolated from the outside and kept under vacuum;
a susceptor 200 rotatably installed in the reacting chamber 100 and on which at least one substrate P is placed; and
an injector 300, including independently formed first and second gas passages 340 and 350, and first and second gas injecting pipes 370 and 380, communicating with the respective gas passages 340 and 350 at respective inlets, for injecting respective first and second gases G1 and G2 onto the susceptor 200, the injector 300 injecting the different gases independently,
wherein a portion, corresponding to a central region 210 of the susceptor 200, is installed with only the second gas injecting pipe 380 so that only the second gas G2, which is a non-reactive carrier gas, among the first and second gases G1 and G2, is injected at the central region 210 of the susceptor 200.

2. A chemical vapor deposition unit comprising:
a reaction chamber 100 isolated from the outside and kept under vacuum;
a susceptor 200, on which at least one substrate P is placed, rotatably installed in the reaction chamber 100; and
an injector 300, including independently formed first and second gas passages 340 and 350, and first and second gas injecting pipes 370 and 380, communicating with the respective gas passages 340 and 350 at respective inlets, for injecting respective first and second gases G1 and G2 onto the susceptor 200, the injector 300 injecting the different gases independently,
wherein the injector 300 further includes a gas injecting part 331 communicating with the second gas passage 350 so that a carrier gas, only the second gas G2, which is a non-reactive carrier gas, among the first and second gases G1 and G2, is injected to a central region 210 of the susceptor 200.

3. The chemical vapor deposition unit as set forth in claim 2, wherein the gas injecting part 331 is formed convexly toward the susceptor 200 so that the second gas G2 is injected to an outside the susceptor 200.

4. The chemical vapor deposition unit as set forth in claim 2 or claim 3, wherein a second gas region 390 having a cross-sectional area greater than that of other region is further formed between the second gas passage 350 and the gas injecting part 331.

5. The chemical vapor deposition unit as set forth in claim 4, wherein the susceptor 200 corresponding to the gas injecting part 331 is further formed with a guide 220 for guiding a flow of the second gas G2 injected from the gas injecting part 331.
